Europäisches Patentamt

European Patent Office

Office européen des brevets

(11) Publication number: **0 065 916**
**B1**

(12) **EUROPEAN PATENT SPECIFICATION**

(45) Date of publication of patent specification: **12.10.88**

(51) Int. Cl.⁴: **G 11 C 17/00, H 01 L 27/12**

(21) Application number: **82400892.4**

(22) Date of filing: **14.05.82**

(54) Schottky diode - polycrystalline silicon resistor memory cell.

(30) Priority: **15.05.81 US 263947**

(43) Date of publication of application:
**01.12.82 Bulletin 82/48**

(45) Publication of the grant of the patent:
**12.10.88 Bulletin 88/41**

(84) Designated Contracting States:
**DE FR GB IT NL**

(56) References cited:
**EP-A-0 058 748**
**US-A-3 515 583**
**US-A-4 110 488**
**US-A-4 146 902**
**US-A-4 203 123**

**IBM TECHNICAL DISCLOSURE BULLETIN,
vol.21, no.9, February 1979, New York (US),
V.L. RIDEOUT: "Self-registeringmetal-to-
polysilicon contactingtechnique", pages 3818-
3821**

**PATENTS ABSTRACTS OF JAPAN, vol.3,
no.121, October 11, 1979, Page 56 E 143 & JP -
A - 54 98 536**

(73) Proprietor: **FAIRCHILD SEMICONDUCTOR
CORPORATION**
**10400 Ridgeview Court P.O. Box 1500
Cupertino, California 95014 (US)**

(72) Inventor: **Hingarh, Hemraj K.**
**3446 Woodyend Court
San Jose California 95121 (US)**
Inventor: **Vora, Madhukar B.**
**110 Lansberry Court
Los Gatos California 95030 (US)**

(74) Representative: **Dipl.-Ing. H. Marsch Dipl.-Ing. K.
Sparing Dipl.-Phys.Dr. W.H. Röhl Patentanwälte
Rethelstrasse 123 Postfach 14 02 68
D-4000 Düsseldorf (DE)**

## Description

Background of the invention
Field of the invention

This invention relates to integrated circuit structures and processes for fabricating them, and in particular to a compact series connected resistor and diode which may be used as a read only memory cell.

Description of the prior art

Conventional programmable read only memories (PROM) use either P—N junction diodes or Schottky diodes in series with a fuse. Unfortunately, as the number of such devices increases, the capacitance of the P—N junctions increase and slow the operating speed of the overall memory array. Furthermore, because the fusing elements require more wafer surface area than do the diodes, a PROM manufactured using such technology is much larger than a comparable ROM.

Another approach to design of memory cells within a PROM is suggested in "A Novel MOS PROM Using Highly Resistive Poly-Si Resistor," M. Tanimoto et al., *IEEE Transactions on Electron Devices*, Vol. ED-27, No. 3, March 1980, pages 517—520. That paper teaches use of a polycrystalline silicon resistor in conjunction with an MOS transistor as a memory element. There is no teaching, however, of the use of a polycrystalline silicon resistor in conjunction with a polycrystalline silicon Schottky diode or with an underlying low resistivity layer.

A memory in which each cell comprises a diode connected in series with a polycrystalline silicon resistor is disclosed in the Patents Abstracts of Japan Vol. 3, No. 121, Oct. 11, 1979, Page 56, E 143, No. 54-98536 and JP—A—54 98536. In order to write information in a memory cell, a current in excess of a threshold value is applied, to decrease the resistance of the polycrystalline silicon resistor in which high dopant concentrations greater than $1 \times 10^{20}$ cm$^{-3}$ are used.

Similar structures of memory cells, each including a Schottky diode in series with a layer of material whose resistance is electrically alterable are disclosed in European patent application EP—A—0058748 which was published after the date of filing of the present application but which is part of the state of the art in the sense of Article 54 (3), provided its content has a validly claimed priority.

Summary of the invention

This invention relates to an integrated circuit structure in which a Schottky diode and a resistor are serially connected between a word line and a bit line in an array of memory cells. By fabricating the resistor from intrinsic polycrystalline silicon, the resistor will operate initially in a first highly resistive state. Application of sufficient potential across the resistor, however, will cause an irreversible change in the polycrystalline silicon to substantially lower the resistance of the resistor. The two states (high and low resistance) of the resistor may be used to store a binary bit of information.

In one embodiment a method of fabricating an integrated circuit memory cell fabricated according to this invention includes the steps of claim 1.

In another embodiment, the invention relates to an integrated circuit memory cell structure according to claim 24.

Brief description of the drawings

Fig. 1 is a cross-section of an integrated circuit structure fabricated using well-known process steps.

Fig. 2 is a subsequent cross-sectional view after etching and oxidizing the structure shown in Fig. 1.

Fig. 3 is a subsequent cross-sectional view after deposition of a layer of metal across the surface of the structure.

Fig. 4 is a top view of the structure shown in Fig. 3.

Fig. 5a and. Fig. 5b are cross-sectional views showing two embodiments of the memory cell.

Figs. 6a and 6b are schematic drawings of the circuits created by the structures depicted in Figs. 5a and 5b, respectively.

Fig. 7 is a graph illustrating the two states which each of the structures shown in Fig. 5a and 5b may have.

Fig. 8 is a graph showing the voltage required to cause the polycrystalline silicon resistor to change state as a function of thickness.

Description of the preferred embodiments

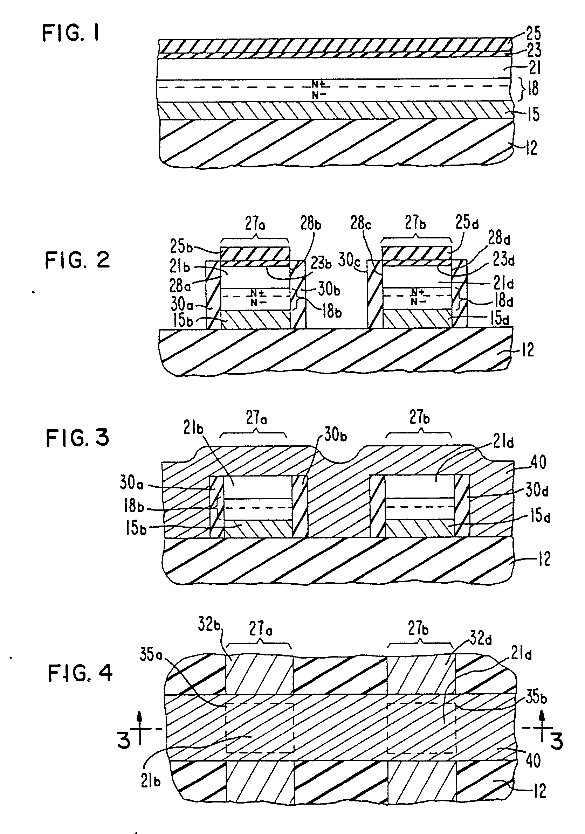

Fig. 1 is a cross-sectional view of an integrated circuit structure which may be fabricated using well-known technology. On an insulating substrate 12, typically silicon dioxide, a layer 15 of metal silicide is deposited. Typically the insulating substrate 12 will comprise a layer of silicon dioxide formed on an underlying region of silicon in which other electronic components, both active and passive, may be fabricated. In the preferred embodiment the metal silicide is tungsten silicide deposited using chemical vapor deposition to a thickness of 1,000 angstroms. On the upper surface of tungsten silicide 15a layer of semiconductor material 18 is deposited. In the preferred embodiment layer 18 is chemical vapor deposited polycrystalline silicon 2,000 angstroms thick. After deposition, phosphorous or another N conductivity type impurity is implanted into layer 18 to lightly dope it to an impurity concentration of about $10^{17}$ atoms per cubic centimeter. The upper portion of layer 18, typically the top 1,000 angstroms, is more heavily doped by ion implantation with N type impurity, for example to a concentration of $10^{20}$ atoms per cubic centimeter. As will be evident, layer 15 provides an electrical connection to layer 18, while the more heavily doped portion of layer 18 provides an electrical connection between the lower portion of layer 18 and an overlying layer formed on the upper surface of layer 18.

On the upper surface of layer 18 another layer of semiconductor material 21 is deposited. Layer 21 will typically be intrinsic polycrystalline silicon, and accordingly will have very high resistivity. Layer 21 is deposited by chemical vapor deposition to a thickness of about 3,000 angstroms. On the upper surface of layer 21 a relatively thin layer of silicon dioxide 23 is formed, typically by a thermal process. In the preferred embodiment layer 23 is 200 angstroms thick and is created by heating the underlying structure to a temperature of 1,000°C for 10 minutes in oxygen.

A layer 25 of silicon nitride approximately 1,000 angstroms thick is then formed using chemical vapor deposition. Nitride 25 prevents further oxidation of the upper surface of semiconductor material 21 during subsequent processing.

Using well-known integrated circuit fabrication technology, the structure shown in Fig. 1 is patterned into one or more strips 27a, 27b, etc. In the preferred embodiment this is accomplished by masking and etching silicon nitride layer 25 to remove it from everywhere except where the strips 27a and 27b are desired. Following this step the remaining regions 25b and 25d of nitride layer 25 themselves serve as a mask for the removal of all underlying materials down to the surface of the insulating substrate 12. In the preferred embodiment, the undesired portions of the layers underlying silicon nitride 25 are removed by sequentially plasma etching them, for example, with etch gases containing $CF_4$ and $CCl_4$, respectively. Because the plasma etching proceeds anisotropically, the strips will have substantially vertical side walls 28a, 28b, 28c, and 28d. Isotropic etching processes, for example etching with appropriate solutions, may also be employed to remove the undesired portions of layers 15, 18, 21, and 23, thereby leaving silicide regions 15b and 15d, polycrystalline silicon 18b, 18d, 21b and 21d, and silicon dioxide 23b and 23d, respectively.

Following the definition of strips 27a, etc., the structure is oxidized to create regions of silicon dioxide 30a, 30b, 30c, and 30d. These regions of silicon dioxide will later serve to prevent short circuiting between an overlying metal layer and the sides of layers 15, 18 and 21. The resulting conductive strips as shown in Fig. 2 are termed bit lines herein. As will be explained, a subsequently formed strip of metal as shown in Fig. 3 will create a word line. Upon application of a desired potential to the word line, the state of any cell on that word line may be determined by sensing the condition of that cell's bit line, or vice versa. Of course the terms "bit" and "word" are arbitrarily chosen and could be interchanged.

The silicon nitride 25 is then removed from the upper surface of the strips 27 and a layer of silicon dioxide 32 is thermally formed on the upper surface of silicon dioxide 23. Layer 32 is not shown in Fig. 3 because, as will be explained, it is subsequently removed. Layer 32 is shown in Fig. 4. Silicon dioxide 32 will be approximately 1,000 angstroms thick and formed by heating the structure to a temperature of 1,000°C for 60 minutes in steam.

As shown in Fig. 4, the silicon dioxide 32 is then removed from regions of the surface of the strips 27a and 27b to form windows 35a and 35b to expose underlying silicon layer 21. This may be accomplished using photolithographic techniques to define windows 35, followed by dip etching the oxide in a 10:1 dilute solution of $H_2O$ and HF. Finally, as shown in Figs. 3 and 4, a layer of metal 40, typically aluminum 7,000 angstroms thick, is deposited across the surface of the structure and defined into word lines extending generally perpendicular to the bit lines.

Fig. 4 is a top view of the structure shown in Fig. 3. The word line 40 crosses bit lines 27a and 27b, and as shown, is in electrical contact with silicon 21b and silicon 21d through windows 35a and 35b in silicon dioxide 32b and 32d.

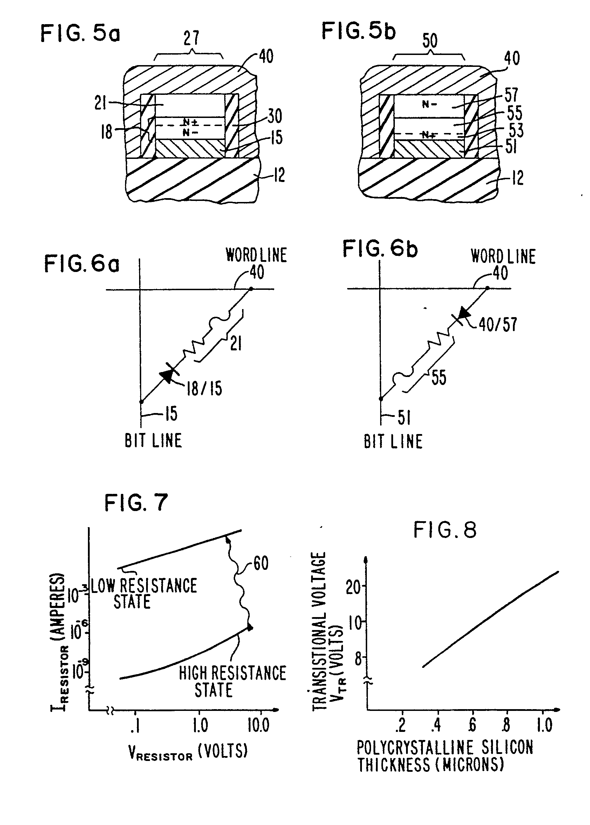

Figs. 5a and 5b illustrate two embodiments of the invention, with Fig. 5a illustrating the embodiment described in conjunction with Figs. 1 to 4. In the embodiment shown in Fig. 5b, the arrangement of the layers in the strip 50 is different from that depicted in strip 27 in Fig. 5a. In strip 50 an underlying layer of tungsten silicide 51 is formed on the surface of silicon dioxide 12. A heavily doped layer of polycrystalline silicon 53 about 1,000 angstroms thick is formed on metal silicide 51, followed by a layer of intrinsic polycrystalline silicon 55 approximately 3,000 angstroms thick. A layer of lightly doped polycrystalline silicon 57 about 2,000 angstroms thick is deposited on layer 55. In the preferred embodiment, to provide a better connection between layers 57 and 40 the upper layer 57 of polycrystalline silicon will be laser annealed. An alternate technique for fabricating the embodiment shown in Fig. 5b is to deposit layers 53, 55 and 57 as a single thick layer, and then use ion implantation to create the desired impurity doping. The impurity concentrations for layers 53, 55 and 57 in Fig. 5b correspond to those for the upper portion of layer 18, layer 21 and the lower portion of layer 18, respectively, in Fig. 5a.

For the structure shown in Fig. 5a, the Schottky diode is created by the interface between layer 18 and layer 15, while layer 21 functions as a resistor. For the structure shown in Fig. 5b the Schottky diode is created by the interface between metal 40 and lightly doped polycrystalline silicon 57, while layer 55 functions as a resistor.

Figs. 6a and 6b are schematics of the memory cells shown in Figs. 5a and 5b, respectively. In each of Figs. 6a and 6b the programmable memory cell is connected between word line 40 and bit line 15 (Fig. 6a) or 51 (Fig. 6b). As is apparent from a comparison of Figs. 5 and 6, the primary difference between the different embodiments is the arrangement of the individual elements within the cell. In particular, the Schottky diode is connected to the word line and the resistor 55 is connected to the bit line in Figs. 5b and 6b. In Figs. 5a and 6a this arrangement is reversed.

Fig. 7 illustrates the current-voltage relationship of the polycrystalline silicon resistor 21 (in Fig. 5a) or 55 (in Fig. 5b). As shown, the resistor will operate in one of two states, termed herein a high resistance state and a low resistance state. In the high resistance state the resistor's characteristics are shown in the designated curve in Fig. 7. For an applied voltage on the order of one volt, the current flow will be on the order of $10^{-9}$ amperes. At a particular threshold voltage (described in conjunction with Fig. 8), for example, that designated by the triangle, the current-voltage characteristics of the resistor will change dramatically and irreversibly to a low resistance state. This is designated in Fig. 7 by the curved line 60 connecting the high resistance state curve with the low resistance state curve. Once the threshold voltage is surpassed, the resistor will thereafter operate, regardless of the applied voltage, in the low resistance state. As shown by Fig. 7, the resistance of the resistor is several orders of magnitude greater in the high resistance state than in the low resistance state. As explained previously, the change of state of the resistor may be used to indicate a binary bit.

Although the precise mechanism by which the condition of the resistor irreversibly changes upon application of the suitably high threshold voltage is still unknown, it is understood that the transitional voltage depends upon the temperature at which the polycrystalline silicon resistor is formed and the thickness of the polycrystalline silicon. A typical relationship between transitional voltage and polycrystalline silicon thickness, for polycrystalline silicon formed at less than 700°C, is shown in Fig. 8. As indicated, for a thickness of 0.6 microns, the resistor will irrevocably change state upon application of approximately a 15 volt signal.

The change of state of the resistor may be most readily utilized in an array of memory cells by programming the desired cells with a suitably high potential to cause the resistors in those cells to change state. The memory array is then operated with potentials substantially lower than this threshold voltage to sense the high or low resistance state of the individual resistors within the array.

Although several embodiments of the invention have been discussed herein, these embodiments are intended to be illustrative of the invention rather than limiting the invention, which is defined by the scope of the appended claims.

**Claims**

1. A method of fabricating an integrated circuit memory cell structure having a plurality of cells each comprising a Schottky diode in series with a resistive element which undergoes a irreversible transition from a high resistance state to a low resistance state characterized by the steps of:

depositing a bottom layer (15, 51) of electrically conductive material on a substrate (12) of insulative material;

sequentially fabricating a plurality of layers (18, 21, 53, 55, 57) of semiconductor material on the bottom layer, a selected layer (21, 55) of the plurality of layers being substantially free of impurities; and

forming an upper layer (40) of electrically conductive material in electrical contact with only the uppermost layer of the plurality of layers;

forming an upper contact between the upper layer and the uppermost layer; and

forming a lower contact between the bottom layer and the intervening layer adjacent to the bottom layer;

wherein one of the upper contact and lower contact is a Schottky contact.

2. The method of Claim 1 characterized in that the step of sequentially fabricating a plurality of layers comprises:

depositing a first layer (18) on the bottom layer (15);

introducing a selected impurity into the first layer; and

depositing the selected layer (21) on the first layer.

3. The method of Claim 1 or 2 characterized in that the uppermost layer is the selected layer (21).

4. The method of Claim 3 characterized in that the selected layer (21) and the first layer (18) comprise polycrystalline silicon.

5. The method of Claim 2, 3 or 4 characterized in that the selected impurity is not uniformly distributed throughout the first layer (18).

6. The method of any previous claim characterized in that the bottom layer (15, 51) comprises metal silicide and the upper layer (40) comprises metal.

7. The method of any previous claim characterized in that the bottom layer (15, 51) comprises tungsten silicide and the upper layer (40) comprises metal.

8. The method of Claim 1 characterized in that the step of sequentially fabricating comprises:

depositing a first layer (53) on the bottom layer (51);

introducing a selected impurity into the first layer (53);

depositing the selected layer (55) on the first layer (53);

depositing a second layer (57) on the selected layer (55); and

introducing the selected impurity into the second layer (57).

9. The method of Claim 8 characterized in that the second layer (57) is the uppermost layer.

10. The method of claim 8 or 9 characterized in that each of the first layer (53), the selected layer (55) and the second layer (57) comprise polycrystalline silicon.

11. The method of Claim 1 characterized in that in said plurality of layers (18, 21, 53, 55, 57) of semiconductor material, said selected layer (21, 55) is intrinsic which is substantially free of impurities and in that one of said layers is doped which is selectively doped with an impurity; and further comprising the steps of:

removing selected portions of the sequentially deposited layers to create at least one first strip of the sequentially deposited layers extending across the insulating substrate (12);

fabricating insulating material (32) on the at least one first strip to cover all of the strips except a desired surface of the uppermost of the plurality of layers; and

forming a strip of second electrically conductive material (40) which crosses the at least one first strip and does not electrically contact any of the strip except the uppermost layer of the plurality of layers.

12. The method of Claim 11 characterized in that the intrinsic layer (21) is deposited on the doped layer (18).

13. The method of Claim 12 characterized in that the doped layer (18) includes a lower and an upper portion, the upper portion containing more of the impurity than the lower portion.

14. The method of Claim 11, 12 or 13 characterized in that the strip of second electrically conductive material (40) is substantially perpendicular to the at least one first strip.

15. The method of any one of Claims 11—14 characterized in that the bottom electrically conductive layer (15, 51) comprises metal silicide and the second electrically conductive layer (40) comprises metal.

16. The method of any one of Claims 11—15 characterized in that the bottom electrically conductive layer (15, 51) comprises tungsten silicide and the second electrically conductive layer (40) comprises aluminum.

17. The method of any one of Claims 11—16 characterized in that the doped layer (57) is deposited on the intrinsic layer (55).

18. The method of Claim 17 characterized in that a third layer (53) separates the intrinsic layer (55) from the first electrically conductive layer (51).

19. The method of Claim 18 characterized in that the third layer (53) comprises polycrystalline silicon doped with the same impurity as the doped layer (57).

20. The method of any one of Claims 11—19 characterized by the step of depositing a layer of silicon nitride (25) on the uppermost of the plurality of layers (18, 21, 53, 55, 57) and subsequently removing the silicon nitride from regions of the uppermost of the plurality of layers wherever the strip of second electrically conductive material (40) crosses the at least one strip.

21. The method of Claim 1 characterized in that the step of fabricating a plurality of layers includes:

depositing on the bottom layer (51) a layer of semiconductor material (53, 55, 57) having a lower and an upper surface;

introducing a selected impurity into the layer of semiconductor material (53, 55, 57) to create a lower region (53) of impurity near the lower surface and an upper region (57) of impurity near the upper surface; and in that

the upper layer of electrically conductive material (40) is in electrical contact with only the upper surface.

22. The method of Claim 21 characterized in that the step of introducing an impurity comprises implanting ions of the impurity.

23. The method of any previous claim characterized by the step of forming a contact area of the uppermost layer of the plurality of layers (18, 21, 53, 55, 57) substantially self aligned vertically with its side edges for contacting the upper layer.

24. An integrated circuit memory cell structure having a plurality of cells each comprising a Schottky diode in series with a resistive element which undergoes an irreversible transition from a high resistance state to a low resistance state characterized by:

a substrate (12) of insulative material;

a bottom layer (15, 51) of electrically conductive material disposed on the substrate;

a plurality of intervening layers (18, 21, 53, 55, 57) of semiconductor material disposed one atop the other on the bottom layer, a selected layer (21, 55) of the plurality being substantially free of impurities; and

an upper layer (40) of electrically conductive material disposed on and in electrical contact with only the uppermost layer of the plurality of intervening layers;

an upper contact between the third layer and the uppermost layer; and

a lower contact between the bottom layer and the intervening layer adjacent to the bottom layer;

wherein one of the upper contact and lower contact is a Schottky contact.

25. The structure of Claim 24 characterized in that the uppermost layer is the selected layer (21).

26. The structure of Claim 24 or 25 characterized in that the selected layer (21) is separated from the bottom layer (15) by a second layer (18) of the plurality of intervening layers.

27. The structure of Claim 26 characterized in that a selected impurity is distributed nonuniformly throughout the second layer (18).

28. The structure of Claim 27 characterized in that more of the selected impurity is present in that portion of the second layer (18) contiguous to the selected layer (21) than in other portions of the second layer.

29. The structure of any one of claims 24—28 characterized in that the selected layer (21) comprises intrinsic polycrystalline silicon.

30. The structure of Claim 29 characterized in that the second layer (18) comprises polycrystalline silicon doped with an N conductivity type impurity.

31. The structure of any one of Claims 26—30 characterized in that the bottom layer (15) comprises metal silicide.

32. The structure of Claim 31 characterized in that the metal silicide comprises tungsten silicide.

33. The structure of any one of claims 24—32

characterized in that the upper layer (40) comprises metal.

34. The structure of any one of claims 24—33 characterized in that the insulating substrate (12) comprises silicon dioxide.

35. The structure of Claim 24 characterized in that a region of silicon dioxide (30) separates the upper layer from the bottom layer and all of the plurality of intervening layers except the uppermost layer and in that electrical contact is maintained between each of the intervening layers in series.

36. The structure of Claim 24 or 35 characterized in that the plurality of intervening layers comprise the selected layer (55), a first layer (53), and a second layer (57).

37. The structure of Claim 36 characterized in that the selected layer (55) separates the first layer (53) from the second layer (57).

38. The structure of Claim 37 characterized in that the first layer (53) is disposed on the bottom layer (51).

39. The structure of any one of claims 36—38 characterized in that the first layer (53) contains more of a selected impurity than the second layer (57), and the first layer (53) provides an ohmic connection between the bottom layer (51) and the selected layer (55).

40. The structure of Claim 39 characterized in that the selected layer (55) comprises intrinsic polycrystalline silicon and each of the first layer and the second layer (53, 57) comprise polycrystalline silicon doped with an N conductivity type impurity.

41. The structure of any one of claims 24—40 characterized in that the bottom layer (15, 51) and the upper layer (40) each comprise parallel electrically conductive lines and wherein both the upper (40) and the bottom (15, 51) layer comprise lines which are substantially perpendicular to each other.

42. The structure of any of claims 24—41 characterized in that the upper layer (40) contacts the uppermost layer through a contact area of the uppermost layer self aligned vertically with its side edges.

**Patentansprüche**

1. Ein Verfahren der Herstellung einer integrierten Speicherzellen-Schaltkreisstruktur mit einer Mehrzahl von Zellen, von denen jede eine Schottky-Diode in Serie mit einem Widerstandselement umfaßt, das einem irreversiblen Übergang von einem Zustand hohen Widerstands zu einem Zustand niedrigen Widerstands unterliegt, gekennzeichnet durch die Schritte:

Aufbringen einer Bodenschicht (15, 51) auf einem Substrat (12) aus isolierendem Material;

Sequenzielle Herstellung einer Mehrzahl von Schichten (18, 21, 53, 55, 57) aus Halbleitermaterial auf der Bodenschicht, wobei eine ausgewählte Schicht (21, 55) aus der Mehrzahl von Schichten im wesentlichen frei von Störstoffen ist; und

Bildung einer oberen Schicht (40) aus elektrisch leitendem Material in elektrischem Kontakt mit nur der obersten Schicht der Mehrzahl von Schichten;

Bildung eines oberen Kontakts zwischen der oberen Schicht und der obersten Schicht; und

Bildung eines unteren Kontakts zwischen der Bodenschicht und der Zwischenschicht nächst der Bodenschicht;

wobei einer der oberen bzw. unteren Kontakte ein Schottky-Kontakt ist.

2. Das Verfahren nach Anspruch 1, dadurch gekennzeichnet, daß der Schritt der sequenziellen Herstellung einer Mehrzahl von Schichten umfaßt:

Aufbringen einer ersten Schicht (18) auf der Bodenschicht (15);

Einführen eines ausgewählten Störstoffs in die erste Schicht; und

Aufbringen der ausgewählten Schicht (21) auf der ersten Schicht.

3. Das Verfahren nach Anspruch 1 oder 2, dadurch gekennzeichnet, daß die oberste Schicht die ausgewählte Schicht (21) ist.

4. Das Verfahren nach Anspruch 3, dadurch gekennzeichnet, daß die ausgewählte Schicht (21) und die erste Schicht (18) polykristallines Silicium umfassen.

5. Das Verfahren nach Anspruch 2, 3 oder 4, dadurch gekennzeichnet, daß der ausgewählte Störstoff ungleichförmig über die erste Schicht (18) verteilt ist.

6. Das Verfahren nach einem der vorangehenden Ansprüche, dadurch gekennzeichnet, daß die Bodenschicht (15, 51) Metallsilicit und die obere Schicht (40) Metall umfaßt.

7. Das Verfahren nach einem der vorangehenden Ansprüche, dadurch gekennzeichnet, daß die Bodenschicht (15, 51) Wolframsilicit umfaßt und die obere Schicht (40) Metall umfaßt.

8. Das Verfahren nach Anspruch 1, dadurch gekennzeichnet, daß der Schritt der sequenziellen Herstellung umfaßt:

Aufbringen einer ersten Schicht (53) auf die Bodenschicht (51);

Einführen eines ausgewählten Störstoffs in die erste Schicht (53);

Aufbringen der ausgewählten Schicht (55) auf die erste Schicht (53);

Aufbringen einer zweiten Schicht (57) auf die ausgewählte Schicht (55); und

Einführen des ausgewählten Störstoffs in die zweite Schicht (57).

9. Das Verfahren nach Anspruch 8, dadurch gekennzeichnet, daß die zweite Schicht (57) die oberste Schicht ist.

10. Das Verfahren nach Anspruch 8 oder 9, dadurch gekennzeichnet, daß jede der ersten Schicht (53), der ausgewählten Schicht (55) und der zweiten Schicht (57) polykristallines Silicium umfaßt.

11. Das Verfahren nach Anspruch 1, dadurch gekennzeichnet, daß in der genannten Mehrzahl von Schichten (18, 21, 53, 55, 57) aus Halbleitermaterial die genannte ausgewählte Schicht (21, 55) eigenleitend ist, welche im wesentlichen frei von Störstoffen ist, und daß eine der genannten Schichten dotiert ist, welche selektiv mit einem Störstoff dotiert ist, und ferner die Schritte umfassend:

Abtragen ausgewählter Bereiche der sequenziell aufgebrachten Schichten zum Erzeugen mindestens eines erstens Streifens aus den sequenziell aufgebrachten Schichten, welche sich über das isolierende Substrat (12) erstreckt;

Herstellen von Isoliermaterial (32) auf dem mindestens einen ersten Streifen zum Abdecken des gesamten Streifens mit Ausnahme eines gewünschten Flächenbereichs auf der obersten der Mehrzahl von Schichten; und

Bildung eines Streifens aus zweitem elektrisch leitendem Material (40), der den mindestens einen ersten Streifen kreuzt und nicht in elektrischem Kontakt steht mit dem Streifen mit Ausnahme der obersten Schicht der Mehrzahl von Schichten.

12. Das Verfahren nach Anspruch 11, dadurch gekennzeichnet, daß die eigenleitende Schicht (21) auf der dotierten Schicht (18) aufgebracht ist.

13. Das Verfahren nach Anspruch 12, dadurch gekennzeichnet, daß die dotierte Schicht (18) einen unteren und einen oberen Anteil umfaßt, wobei der obere Anteil mehr Störstoff enthält als der untere Anteil.

14. Das Verfahren nach Anspruch 11, 12 oder 13, dadurch gekennzeichnet, daß der Streifen aus zweitem elektrisch leitendem Material (40) im wesentlichen senkrecht zu dem mindestens einen ersten Streifen verläuft.

15. Das Verfahren nach einem der Ansprüche 11 bis 14, dadurch gekennzeichnet, daß die elektrisch leitende Bodenschicht (15, 51) Metallsilicit umfaßt und die zweite elektrisch leitende Schicht (40) Metall umfaßt.

16. Das Verfahren nach einem der Ansprüche 11 bis 15, dadurch gekennzeichnet, daß die elektrisch leitende Bodenschicht (15, 51) Wolframsilicit umfaßt und die zweite elektrisch leitende Schicht (40) Aluminium umfaßt.

17. Das Verfahren nach einem der Ansprüche 11 bis 16, dadurch gekennzeichnet, daß die dotierte Schicht (57) auf der eigenleitenden Schicht (55) aufgebracht ist.

18. Das Verfahren nach Anspruch 17, dadurch gekennzeichnet, daß eine dritte Schicht (53) die eigenleitende Schicht (55) von der ersten elektrisch leitenden Schicht (51) trennt.

19. Das Verfahren nach Anspruch 18, dadurch gekennzeichnet, daß die dritte Schicht (53) polykristallines Silicium umfaßt, dotiert mit demselben Störstoff wie die dotierte Schicht (57).

20. Das Verfahren nach einem der Ansprüche 11 bis 19, gekennzeichnet durch den Schritt der Aufbringung einer Schicht aus Siliciumnitrit (25) auf der obersten der Mehrzahl von Schichten (18, 21, 53, 55, 57) und nachfolgendes Abtragen des Siliciumnitrits aus Bereichen der obersten der Mehrzahl von Schichten überall dort, wo der Streifen auf zweitem elektrisch leitendem Material (40) den mindestens einen Streifen kreuzt.

21. Das Verfahren nach Anspruch 1, dadurch gekennzeichnet, daß der Schritt der Herstellung einer Mehrzahl von Schichten umfaßt:

Aufbringen einer Schicht aus Halbleitermaterial (53, 55, 57) mit einer unteren und einer oberen Oberfläche auf der Bodenschicht (51);

Einführen eines ausgewählten Störstoffs in die Schicht aus Halbleitermaterial (53, 55, 57) zum Erzeugen eines unteren Störstoffbereichs (53) nahe der unteren Oberfläche und eines oberen Störstoffbereichs (57) nahe der oberen Oberfläche; und daß

die obere Schicht aus elektrisch leitendem Material (40) in elektrischem Kontakt nur mit der oberen Oberfläche steht.

22. Das Verfahren nach Anspruch 21, dadurch gekennzeichnet, daß der Schritt des Einführens eines Störstoffes das Implantieren von Ionen der Störstoffes umfaßt.

23. Das Verfahren nach einem der vorangehenden Ansprüche, gekennzeichnet durch den Schritt der Bildung eines Kontaktfeldes der obersten Schicht der Mehrzahl von Schichten (18, 21, 53, 55, 57) im wesentlichen vertikal selbstausgefluchtet mit seinen Seitenkanten für das Kontaktieren der oberen Schicht.

24. Eine integrierte Speicherzellen-Schaltkreisstruktur mit einer Mehrzahl von Zellen, von denen jede eine Schottky-Diode in Serie mit einem Widerstandselement umfaßt, das einer unumkehrbaren Umwandlung von einem Zustand hohen Widerstandes in einen Zustand niedrigen Widerstandes unterworfen wird, gekennzeichnet durch:

ein Substrat (12) aus isolierendem Material;

eine Bodenschicht (15, 51) aus elektrisch leitendem Material, aufgebracht auf dem Substrat;

eine Mehrzahl von Zwischenschichten (18, 21, 53, 55, 57) aus Halbleitermaterial, aufgebracht übereinander auf der Bodenschicht, wobei eine ausgewählte Schicht (21, 55) der Mehrzahl im wesentlichen frei von Störstoffen ist; und

eine obere Schicht (40) aus elektrisch leitendem Material, aufgebracht auf der obersten Schicht der Mehrzahl von Zwischenschichten und in elektrischem Kontakt nur mit dieser;

einen oberen Kontakt zwischen der dritten Schicht und der obersten Schicht; und

einen unteren Kontakt zischen der Bodenschicht und der Zwischenschicht nächst der Bodenschicht;

wobei einer der oberen und unteren Kontakte ein Schottky-Kontakt ist.

25. Die Struktur nach Anspruch 24, dadurch gekennzeichnet, daß die oberste Schicht die ausgewählte Schicht (21) ist.

26. Die Struktur nach Anspruch 24 oder 25, dadurch gekennzeichnet, daß die ausgewählte Schicht (21) von der Bodenschicht (15) durch eine zweite Schicht (18) der Mehrzahl von Zwischenschichten getrennt ist.

27. Die Struktur nach Anspruch 26, dadurch gekennzeichnet, daß ein ausgewählter Störstoff ungleichförmig über die zweite Schicht (18) verteilt ist.

28. Die Struktur nach Anspruch 27, dadurch gekennzeichnet, daß mehr des ausgewählten Störstoffes in jenem Teil der zweiten Schicht (18) vorhanden ist, der anschließt an die ausgewählte Schicht (21), als in dem anderen Abschnitt der zweiten Schicht.

29. Die Struktur nach einem der Ansprüche 25 bis 28, dadurch gekennzeichnet, daß die ausgewählte Schicht (21) eigenleitendes polykristallines Silicium umfaßt.

30. Die Struktur nach Anspruch 29, dadurch gekennzeichnet, daß die zweite Schicht (18) polykristallines Silicium, dotiert mit einem Störstoff vom N-Leitfähigkeitstyp umfaßt.

31. Die Struktur nach einem der Ansprüche 26 bis 30, dadurch gekennzeichnet, daß die Bodenschicht (15) Metallsilicit umfaßt.

32. Die Struktur nach Anspruch 31, dadurch gekennzeichnet, daß das Metallsilicit Wolframsilicit umfaßt.

33. Die Struktur nach einem der Ansprüche 24 bis 32, dadurch gekennzeichnet, daß die obere Schicht (40) Metall umfaßt.

34. Die Struktur nach einem der Ansprüche 24 bis 33, dadurch gekennzeichnet, daß das isolierende Substrat (12) Siliciumdioxid umfaßt.

35. Die Struktur nach Anspruch 24, dadurch gekennzeichnet, daß ein Bereich von Siliciumdioxid (30) die obere Schicht von der Bodenschicht trennt und alle der Gesamtheit von Zwischenschichten mit Ausnahme der obersten Schicht, und daß elektrischer Kontakt zwischen jeder der in Serie liegenden Zwischenschichten besteht.

36. Die Struktur nach Anspruch 24 oder 35, dadurch gekennzeichnet, daß die Mehrzahl von Zwischenschichten die ausgewählte Schicht (55), eine erste Schicht (53) und eine zweite Schicht (57) umfaßt.

37. Die Struktur nach Anspruch 36, dadurch gekennzeichnet, daß die ausgewählte Schicht (55) die erste Schicht (53) von der zweiten Schicht (57) trennt.

38. Die Struktur nach Anspruch 37, dadurch gekennzeichnet, daß die erste Schicht (53) auf der Bodenschicht (51) aufgebracht ist.

39. Die Struktur nach einem der Ansprüche 36 bis 38, dadurch gekennzeichnet, daß die erste Schicht (53) mehr eines ausgewählten Störstoffes enthält als die zweite Schicht (57), und die erste Schicht (53) eine Ohmsche Verbindung zwischen der Bodenschicht (51) und der ausgewählten Schicht (55) herstellt.

40. Die Struktur nach Anspruch 39, dadurch gekennzeichnet, daß die ausgewählte Schicht (55) eigenleitendes polykristallines Silicium umfaßt, und daß jede der ersten und der zweiten Schichten (53, 57) polykristallines Silicium umfaßt, dotiert mit einem Störstoff vom N-Leitfähigkeitstyp.

41. Die Struktur nach einem der Ansprüche 24 bis 40, dadurch gekennzeichnet, daß die Bodenschicht (15, 51) und die obere Schicht (40) jede parallele elektrisch leitende Leitungen umfassen, und wobei die obere Schicht (40) und die untere Schicht (15, 51) Leitungen umfassen, die im wesentlichen senkrecht zueinander verlaufen.

42. Die Struktur nach einem der Ansprüche 24 bis 41, dadurch gekennzeichnet, daß die obere Schicht (40) die oberste Schicht durch ein Kontaktfeld der obersten Schicht kontaktiert, das vertikal mit seinen Seitenkanten selbstausgefluchtet ist.

**Revendications**

1. Procédé pour fabriquer une structure à cellules de mémoire à circuits intégrés, comportant plusieurs cellules comprenant chacune une diode Schottky branchée en série avec un élément résistif, qui fait l'objet d'une transition irréversible depuis un état de résistivité élevée dans un état de faible résistivité, caractérisé par les étapes consistant à:

déposer une couche inférieure (15, 51) réalisée en un matériau électriquement conducteur sur un substrat (12) réalisé en un matériau isolant;

fabriquer successivement plusieurs couches (18, 21, 53, 54, 57) en un matériau semiconducteur sur la couche inférieure, une couche sélectionnée (21, 55) faisant partie de ces couches étant à peu près exempte d'impuretés; et

former une couche supérieure (40) réalisée en un matériau électriquement conducteur et placée en contact électrique avec uniquement la couche la plus élevée faisant partie de plusieurs couches;

former un contact supérieur entre la couche supérieure et la couche la plus élevée; et

former un contact inférieur entre la couche inférieure et la couche intercalaire adjacente à la couche inférieure;

l'un des contacts supérieur et inférieur étant un contact Schottky.

2. Procédé selon la revendication 1, caractérisé en ce que l'étape de fabrication successive de plusieurs couches inclut:

le dépôt d'une première couche (18) sur la couche inférieure (15);

l'introduction d'une impureté sélectionnée dans la première couche; et

le dépôt de la couche sélectionnée (21) sur la première couche.

3. Procédé selon la revendication 1 ou 2, caractérisé en ce que la couche la plus élevée est la couche sélectionnée (21).

4. Procédé selon la revendication 3, caractérisé en ce que la couche sélectionnée (21) et la première couche (18) comprennent du silicium polycristallin.

5. Procédé selon la revendication 2, 3 ou 4, caractérisé en ce l'impureté sélectionnée n'est pas répartie uniformément dans la première couche (18).

6. Procédé selon l'une quelconque des revendications précédentes, caractérisé en ce que la couche inférieure (15, 51) est constituée par un siliciure métallique et que la couche supérieure (40) est constituée par un métal.

7. Procédé selon l'une quelconque des revendications précédentes, caractérisé en ce que la couche inférieure (15, 51) est constituée par du siliciure de tungstène et que la couche supérieure (40) est constituée par un métal.

8. Procédé selon la revendication 1, caractérisé en ce que l'étape de fabrication successive inclut:

le dépôt d'une première couche (53) sur la couche inférieure (51);

l'introduction d'une impureté sélectionnée dans la première couche (53);

le dépôt de la couche sélectionnée (55) sur la première couche (53);

le dépôt d'une seconde couche (57) sur la couche sélectionnée (55); et

l'introduction et l'impureté sélectionnée dans la seconde couche (57).

9. Procédé selon la revendication 8, caractérisé en ce que la seconde couche (57) est la couche la plus élevée.

10. Procédé selon la revendication 8 ou 9, caractérisé en ce que la première couche (53), la couche sélectionnée (55) et la seconde couche (57) comprennent du silicium polycristallin.

11. Procédé selon la revendication 1, caractérisé en ce que parmi les couches (18, 21, 53, 55, 57) réalisées en un matériau semiconducteur, ladite couche sélectionnée (21, 55) est une couche intrinsèque à peu près exempte d'impuretés et que l'une desdites couches est une couche dopée de façon sélective par une impureté; et inclut en outre les étapes consistant à:

éliminer des parties sélectionnées des couches déponsées successivement pour créer au moins une première bande des couches déposées successivement, de manière qu'elle s'étende en travers du substrat isolant (12);

fabriquer un matériau isolant (12) sur ladite au moins une première bande de manière à recouvrir l'ensemble des bandes hormis au niveau d'une surface désirée de la couche la plus haute des couches; et

former une bande d'un second matériau électriquement conducteur (40), qui recoupe ladite au moins une première bande et n'est en contact électrique avec aucune partie de la bande, hormis avec la couche la plus élevée faisant partie de plusieurs couches.

12. Procédé selon la revendication 11, caractérisé en ce que la couche intrinsèque (21) est déposée sur la couche dopée (18).

13. Procédé selon la revendication 12, caractérisé en ce que la couche dopée (18) comporte une partie inférieure et une partie supérieure, la partie supérieure contenant une quantité plus importante d'impureté que la couche inférieure.

14. Procédé selon la revendication 11, 12 ou 13, caractérisé en ce que la bande formée d'un second matériau électriquement conducteur (40) est à peu près perpendiculaire à ladite au moins une première bande.

15. Procédé selon l'une quelconque des revendications 11—14, caractérisé en ce que la couche électriquement conductrice inférieur (15, 51) est constituée par un siliciure métallique et que la seconde couche électriquement conductrice (40) est constituée par un métal.

16. Procédé selon l'une quelconque des revendications 11—15, caractérisé en ce que la couche électriquement conductrice inférieure (15, 51) est constituée par du siliciure de tungstène et que la seconde couche électriquement conductrice (40) est constituée par de l'aluminium.

17. Procédé selon l'une quelconque des revendications 11—16, caractérisé en ce que la couche dopée (57) est déposée sur la couche intrinsèque (55).

18. Procédé selon la revendication 17, caractérisé en ce qu'une troisième couche (53) sépare la couche intrinsèque (55) de la première couche électriquement conductrice (51).

19. Procédé selon la revendication 18, caractérisé en ce que la troisième couche (53) comporte du silicium polycristallin dopé par la même impureté que la couche dopée (57).

20. Procédé selon l'une quelconque des revendications 11—19, caractérisé par l'étape de dépôt d'une couche de nitrure de silicium (25) sur la couche la plus élevée faisant partie de plusieurs couches (18, 21, 53, 55, 57), et l'élimination ultérieure du nitrure de silicium dans des régions de la couche la plus élevée faisant partie de plusieurs couches, partout où la bande formée du second matériau électriquement conducteur (40) recoupe ladite au moins une première bande.

21. Procédé selon la revendication 1, caractérisé en ce que l'étape de fabrication de plusieurs couches inclut:

le dépôt, sur la couche inférieure (51), d'une couche d'un matériau semiconducteur (53, 55, 57) possédant une surface inférieure et une surface supérieure;

l'introduction d'une impureté sélectionnée dans la couche en matériau semiconducteur (53, 57) de manière à créer une région inférieure d'impureté (53) proche de la surface inférieure, et une région supérieure d'impureté (57) proche de la surface supérieure; et en ce que

la couche supérieure réalisée en un matériau électriquement conducteur (40) est en contact électrique uniquement avec la surface supérieure.

22. Procédé selon la revendication 21, caractérisé en ce que l'étape d'introduction d'une impureté inclut l'implantation d'ions de cette impureté.

23. Procédé selon l'une quelconque des revendications précédentes, caractérisé par l'étape de formation d'une zone de contact de la couche la plus élevée faisant partie de plusieurs couches (18, 21, 53, 55, 57), à peu près auto-alignée verticalement par ses bords latéraux pour l'établissement du contact avec la couche supérieure.

24. Structure à cellules de mémoire à circuits intégrés comportant plusieurs cellules comprenant chacune une diode Schottky branchée en série avec un élément résistif qui est le siège d'une transition irréversible d'un état de résistivité élevé à un état de résistivité faible, caractérisée par:

un substrat (12) réalisé en un matériau isolant;

une couche inférieure (15, 51) réalisée en un matériau électriquement conducteur, disposé sur le substrat;

plusieurs couches intercalaires (18, 21, 53, 55, 57) réalisées en un matériau semiconducteur et superposées sur la couche inférieure, une couche sélectionnée (21, 55) de plusieurs couches étant à peu près exempte d'impuretés; et

une couche supérieure (40) réalisée en un matériau électriquement conducteur disposé sur et en contact électrique avec uniquement la couche la plus élevée de plusieurs couches intercalaires;

un contact supérieur entre la troisième couche et la couche la plus élevée; et

un contact inférieur entre la couche inférieure et la couche intercalaire adjacente à la couche inférieure;

l'un des contacts supérieur et inférieur étant un contact Schottky.

25. Structure selon la revendication 24, caractérisée en ce que la couche la plus élevée est la couche sélectionnée (21).

26. Structure selon la revendication 24 ou 25, caractérisée en ce que la couche sélectionnée (21) est séparée de la couche inférieure (15) par une seconde couche (18) faisant partie de plusieurs couches intercalaires.

27. Structure selon la revendication 26, caractérisée en ce qu'une impureté sélectionnée est répartie d'une manière non uniforme à l'intérieur de la seconde couche (18).

28. Structure selon la revendication 27, caractérisée en ce qu'une plus grande quantité d'impureté sélectionnée est présente dans la partie de la seconde couche (18) adjacente à la couche sélectionnée (21) que dans d'autres parties de la seconde couche.

29. Structure selon l'une quelconque des revendications 24—28, caractérisée en ce que la couche sélectionnée (21) est constituée par du silicium polycristallin intrinsèque.

30. Structure selon la revendication 29, caractérisée en ce que la seconde couche (18) comporte du silicium polycristallin dopé par une impureté possédant un type de conductivité N.

31. Structure selon l'une quelconque des revendications 26—30, caractérisée en ce que la couche inférieure (15) est constituée par un siliciure métallique.

32. Structure selon la revendication 31, caractérisée en ce que le siliciure métallique est constitué par du siliciure de tungstène.

33. Structure selon l'une quelconque des revendications 24—32, caractérisée en ce que la couche supérieure (40) comprend un métal.

34. Structure selon l'une quelconque des revendications 24—33, caractérisée en ce que le substrat isolant (12) est constitué par du bioxyde de silicium.

35. Structure selon la revendication 24, caractérisée en ce qu'une région de bioxyde de silicium (30) sépare la couche supérieure de la couche inférieure et l'ensemble de plusieurs couches intercalaires, hormis la couche la plus élevée, et qu'une contact électrique est maintenu entre chacune des couches intercalaires branchées en série.

36. Structure selon la revendication 24 ou 35, caractérisée en ce que les plusieurs couches intercalaires incluent la couche sélectionnée (55), un première couche (53) et une seconde couche (57).

37. Structure selon la revendication 36, caractérisée en ce que la couche sélectionnée (55) sépare la première couche (53) de la seconde couche (57).

38. Structure selon la revendication 37, caractérisée en ce que la première couche (53) est disposée sur la couche inférieure (51).

39. Structure selon l'une quelconque des revendications 36—38, caractérisée en ce que la première couche (53) contient une plus grande quantité d'une impureté sélectionnée que la seconde couche (57), et que la première couche (53) établit une liaison ohmique entre la couche inférieure (51) et la couche sélectionnée (55).

40. Structure selon la revendication 39, caractérisée en ce que la couche sélectionnée (55) comprend du silicium polycristallin intrinsèque et que chacune des première et seconde couches (53, 57) comprend du silicium polycristallin dopé par une impureté possédant un type de conductivité N.

41. Structure selon l'une quelconque des revendications 24—40, caractérisée en ce que la couche inférieure (15, 51) et la couche supérieure (40) sont constituées par des lignes parallèles électriquement conductrices et que la couche supérieure (40) et la couche inférieure (15, 51) sont constituées par des lignes qui sont à peu près perpendiculaires entre elles.

42. Structure selon l'une quelconque des revendications 24—41, caractérisée en ce que la couche supérieure (40) est en contact avec la couche la plus élevée par l'intermédiaire d'une zone de contact de la couche la plus élevée autoalignée verticalement par ses bords latéraux.

FIG. 1

FIG. 2

FIG. 3

FIG. 4

FIG. 5a

FIG. 5b

FIG. 6a

FIG. 6b

FIG. 7

FIG. 8